# FASCICULE DE BREVET EUROPEEN

(11) **EP 0 976 148 B1**
(45) Date de publication et mention de la délivrance du brevet: **13.12.2006**
(21) Numéro de dépôt: 99903754.2
(22) Date de dépôt: 15.02.1999
(51) Int. Cl.: H01L 21/28

(54) **PROCEDE DE NITRURATION DE LA COUCHE D'OXYDE DE GRILLE D'UN DISPOSITIF SEMICONDUCTEUR**
VERFAHREN ZUR NITRIDIERUNG DER GATTER-OXYDSCHICHT VON EINEM HALBLEITERBAUELEMENT
METHOD FOR NITRIDING THE GATE OXIDE LAYER OF A SEMICONDUCTOR DEVICE

(30) Priorité: 18.02.1998 FR 9801963
(43) Date de publication de la demande: 02.02.2000
(73) Titulaire: FRANCE TELECOM, 75015 Paris (FR); COMMISSARIAT A L'ENERGIE ATOMIQUE, 75015 Paris (FR)
(72) Inventeur: BENSAHEL, Daniel, F-38000 Grenoble (FR); CAMPIDELLI, Yves, F-38000 Grenoble (FR); MARTIN, François, F-38000 Grenoble (FR); HERNANDEZ, Caroline, F-38000 Grenoble (FR)
(74) Mandataire: Casalonga, Axel
(86) Numéro de dépôt international: PCT/FR1999/000328
(87) Numéro de publication internationale: WO 1999/043023

(56) Documents cités:
- SAGNES I ET AL: "Study of nitrogen incorporation in gate oxides using the resistance to oxidation method" RAPID THERMAL AND INTEGRATED PROCESSING V. PROCESSING, RAPID THERMAL AND INTEGRATED PROCESSING V. SYMPOSIUM, SAN FRANCISCO, CA, USA, 8-12 APRIL 1996, pages 251-256, XP002088466 1996, Pittsburgh, PA, USA, Mater. Res. Soc, USA
- KUMAR K ET AL: "OPTIMIZATION OF SUB 3 NM GATE DIELECTRICS GROWN BY RAPID THERMAL OXIDATION IN A NITRIC OXIDE AMBIENT" APPLIED PHYSICS LETTERS, vol. 70, no. 3, 20 janvier 1997, pages 384-386, XP002037772
- GUSEV E P ET AL: "The composition of ultrathin silicon oxynitrides thermally grown in nitric oxide" JOURNAL OF APPLIED PHYSICS, 15 JULY 1997, AIP, USA, vol. 82, no. 2, pages 896-898, XP002088467 ISSN 0021-8979
- SAGNES I ET AL: "Controlled thin oxidation and nitridation in a single wafer cluster tool" RAPID THERMAL AND INTEGRATED PROCESSING IV. SYMPOSIUM, RAPID THERMAL AND INTEGRATED PROCESSING IV. SYMPOSIUM, SAN FRANCISCO, CA, USA, 17-20 APRIL 1995, pages 253-258, XP002088468 1995, Pittsburgh, PA, USA, Mater. Res. Soc, USA

## Description

La présente invention concerne de manière générale un procédé de fabrication de dispositifs semiconducteurs et plus particulièrement un procédé de nitruration de la couche d'oxyde de grille (SiO₂) d'un dispositif semiconducteur, par exemple un dispositif CMOS.

Le procédé de nitruration selon l'invention s'avère particulièrement avantageux pour la fabrication de dispositifs semiconducteurs à couche d'oxyde de grille très fine (≤ 3nm, de préférence ≤ 2,5nm).

Avec la diminution de l'épaisseur de la couche d'oxyde de grille (≤ 3nm) dans les dispositifs semiconducteurs, tels que par exemple les dispositifs PMOS, la diffusion d'atomes de dopant tel que le bore à travers la couche d'oxyde au cours de traitements thermiques ultérieurs de la grille dopée, peut affecter la performance et la fiabilité des dispositifs obtenus.

Différentes solutions ont été envisagées pour remédier à ce problème de diffusion des atomes de dopant à travers la couche d'oxyde de grille.

Une solution à ce problème est la nitruration de la couche d'oxyde de grille.

On a aussi proposé de nitrurer la couche d'oxyde de grille avec NH₃ ou N₂O gazeux.

Cependant, bien que l'oxynitrure formée par NH₃ dans la couche d'oxyde de grille conduise à une barrière acceptable vis-à-vis de la diffusion du dopant (bore), l'incorporation d'atomes d'hydrogène résulte en une présence de charges fixes et en un accroissement du piégeage des électrons.

L'utilisation de N₂O, au contraire, se traduit par une absence de piégeage. Toutefois, l'obtention d'oxynitrures à partir de N₂O exige des processus thermiques coûteux qui sont essentiels pour obtenir la concentration élevée en azote à l'interface Si/SiO₂.

En outre, le recuit dans N₂O s'avère inefficace pour la nitruration de couches d'oxyde minces (< 3nm).

On a récemment proposé d'utiliser NO gazeux pour la nitruration des couches d'oxyde de grille. Dans tous les cas, on faisait initialement croître une couche d'oxyde de grille (SiO₂) sur le substrat de silicium puis on effectuait la nitruration de la couche d'oxyde de grille au moyen de NO gazeux par un processus thermique rapide (RTP). Ce procédé nécessite des températures relativement élevées (850-900°C) et des pressions de 10⁴ Pa ou plus. D'autre part il ne permet pas de précisément localiser la présence d'azote à l'interface entre le substrat et la couche d'oxyde de grille (interface Si/SiO₂).

Le document SAGNES I ET AL: "Study of nitrogen incorporation in gate oxides using the resistance to oxidation method" RAPID THERMAL AND INTEGRATED PROCESSING V. PROCESSING, RAPID THERMAL AND INTEGRATED PROCESSING V. SYMPOSIUM, SAN FRANCISCO, CA, USA, 8-12 APRIL 1996, pages 251-256, XP002088466, Pittsburgh, PA, USA, Mater. Res. Soc, USA décrit la nitruration d'un oxyde chimique à l'aide de NO.

Le document SAGNES I ET AL: "Controlled thin oxidation and nitridation in a single wafer cluster tool" RAPID THERMAL AND INTEGRATED PROCESSING IV. SYMPOSIUM, RAPID THERMAL AND INTEGRATED PROCESSING IV. SYMPOSIUM, SAN FRANCISCO, CA, USA, 17-20 APRIL 1995, pages 253-258, XP00208846, Pittsburgh, PA, USA, Mater. Res. Soc, USA décrit la croissance d'un oxyde à l'aide d' ozone.

La présente invention a donc pour objet de fournir un procédé de nitruration de la couche de grille remédiant aux inconvénients de l'art antérieur.

En particulier, l'invention a pour objet un procédé de nitruration de la couche d'oxyde de grille d'un dispositif semiconducteur permettant de limiter la diffusion du dopant (bore) à travers la couche d'oxyde de grille pour des couches d'oxyde de grille très fines (≤ 2,5nm) et qui permette de localiser la présence de l'azote à l'interface entre le substrat et la couche d'oxyde de grille.

On atteint les buts ci-dessus selon l'invention, en fournissant un procédé de nitruration de la couche d'oxyde de grille d'un dispositif semiconducteur comprenant les étapes suivantes :
- croissance chimique sur un substrat de silicium d'une couche d'oxyde de silicium natif d'une épaisseur au plus égale à 1nm ;
- traitement du substrat revêtu de la couche d'oxyde de silicium natif avec de l'oxyde nitrique gazeux (NO) à une température au plus égale à 700°C et sous une pression au plus égale à 10⁴ Pa pour obtenir une couche d'oxyde de grille comportant des atomes d'azote principalement localisés à l'interface substrat/couche d'oxyde de grille.

La suite de la description se réfère aux figures annexées qui représentent, respectivement :
figures la à ld, une représentation schématique des étapes principales du procédé selon l'invention ;
figure 2, un graphe par spectrographie de masse d'ions secondaires (SIMS) du profil de nitruration d'une couche d'oxyde de silicium "natif" de 1nm, nitrurée par le procédé de l'invention et avant croissance de la couche d'oxyde de grille ;
figure 3, un graphe par SIMS du profil de nitruration après croissance de l'oxyde de grille ;
figure 4, une microphotographie par microscopie électronique de transmission d'une section d'une couche d'oxyde de grille de 2,2nm d'épaisseur obtenue par le procédé de l'invention, et
figure 5, des graphes I(V) en fonction du champ électrique appliqué de différents dispositifs comportant une couche d'oxyde de grille obtenue par le procédé de l'invention et d'un dispositif ayant une couche d'oxyde de grille non nitrurée.

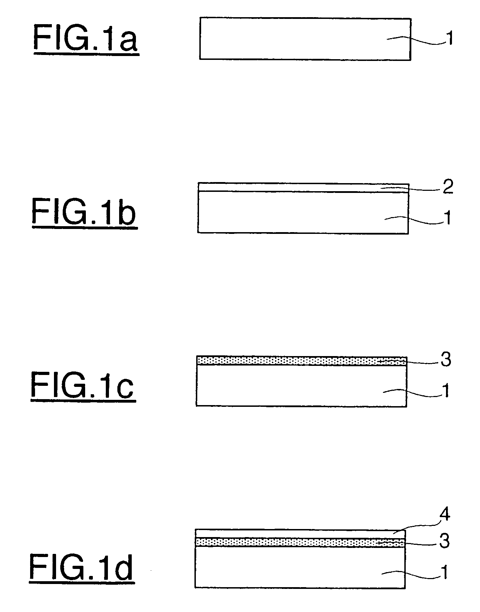

En se référant aux figures 1a à 1d, la première étape du procédé selon l'invention consiste à former chimiquement sur la surface d'un substrat en silicium 1, dopé par exemple par implantation d'atomes de bore, une couche d'oxyde de silicium "natif" 2 d'épaisseur au plus égale à 1nm.

Le substrat de silicium peut être en silicium polycristallin ou monocristallin.

La formation de la couche d'oxyde de silicium "natif" peut être réalisée de la façon suivante :

Après nettoyage de la surface du substrat de silicium 1 par tout procédé classique, on sature la surface du substrat en liaisons Si-H (et H-Si-H) dans une solution aqueuse diluée de HF (généralement de 1% ou moins). Après rinçage à l'eau désionisée et séchage (éventuellement assisté avec de l'alcool isopropylique), le substrat est exposé dans un réacteur à un flux d'ozone (O₃) gazeux (typiquement à une température ≤ 200°C et pendant une durée inférieure à 3 minutes) ou une solution d'eau ozonée (typiquement de l'eau désionisée à température ambiante saturée en ozone).

Dans les deux cas, on obtient une épaisseur d'oxyde équivalente inférieure à 1nm.

Dans le cas de formation de la couche d'oxyde "natif" par un flux d'ozone gazeux, on peut effectuer l'étape suivante de nitruration dans le même réacteur.

L'étape suivante consiste à nitrurer la couche d'oxyde "natif" 2 pour obtenir une couche nitrurée 3. Selon l'invention, cette nitruration s'effectue en mettant en contact dans un réacteur le susbstrat 1 revêtu de la couche d'oxyde "natif" 2 avec du NO gazeux à une température inférieure ou égale à 700°C, de préférence inférieure à 600°C et à une pression inférieure ou égale à 10⁵ Pa, inférieure ou égale à 10³ Pa, pendant une durée de quelque secondes à plusieurs minutes, généralement de 10 secondes à 1 ou 2 minutes.

Une fois la couche d'oxyde de silicium "natif" nitrurée selon le procédé de l'invention, on fait croître une couche d'oxyde de silicium de grille 4 par tout procédé classique.

A titre d'exemple, on peut faire croître la couche d'oxyde de grille 4 en soumettant le substrat revêtu de la couche d'oxyde "natif" nitrurée 3 à une atmosphère d'oxygène sec, pur ou dilué, à une température de 700-850°C. La durée de cette étape de croissance par oxydation est bien évidemment fonction de l'épaisseur voulue pour la couche d'oxyde de grille.

### Exemples

On fait croître chimiquement, comme indiqué ci-dessus, sur une plaque de silicium de 200mm une couche d'oxyde de silicium "natif" de 1nm d'épaisseur.

On effectue la nitruration de cette couche d'oxyde en soumettant la plaque revêtue de la couche d'oxyde "natif" à une atmosphère de NO gazeux sur une pression de 10³ Pa à 550°C pendant trente secondes.

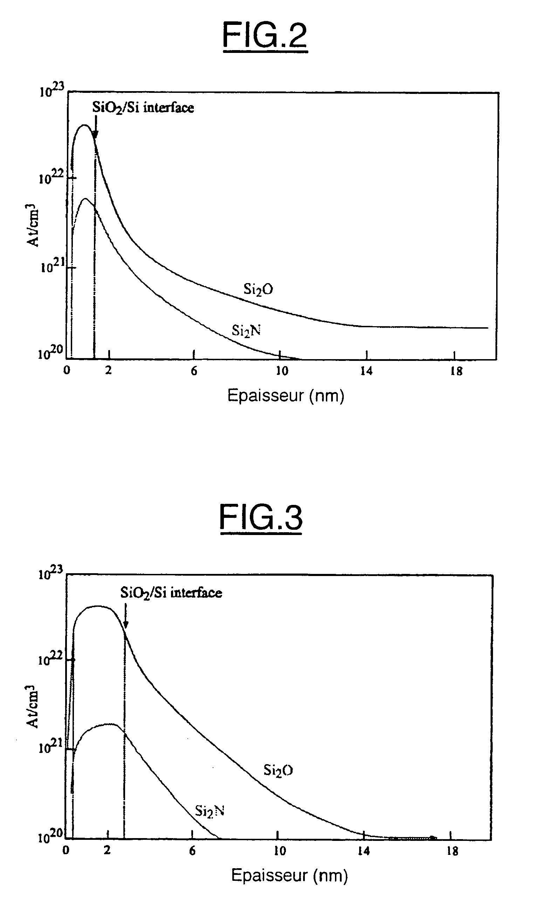

Comme le montre la figure 2, il y a une nitruration notable de couche d'oxyde "natif" (les queues des courbes SiO₂, Si₂N sont des artefacts d'abrasion).

On fait alors croître sur la couche d'oxyde nitrurée une couche d'oxyde de silicium par traitement au four de la plaque de silicium comportant la couche d'oxyde "natif" nitrurée dans une atmosphère d'oxygène sec à 850°C pendant cinq minutes pour obtenir une couche d'oxyde de grille (SiO₂) de 2,2mm d'épaisseur.

La figure 3 montre que l'azote à l'intérieur de la couche d'oxyde est principalement situé près de l'interface Si/SO₂.

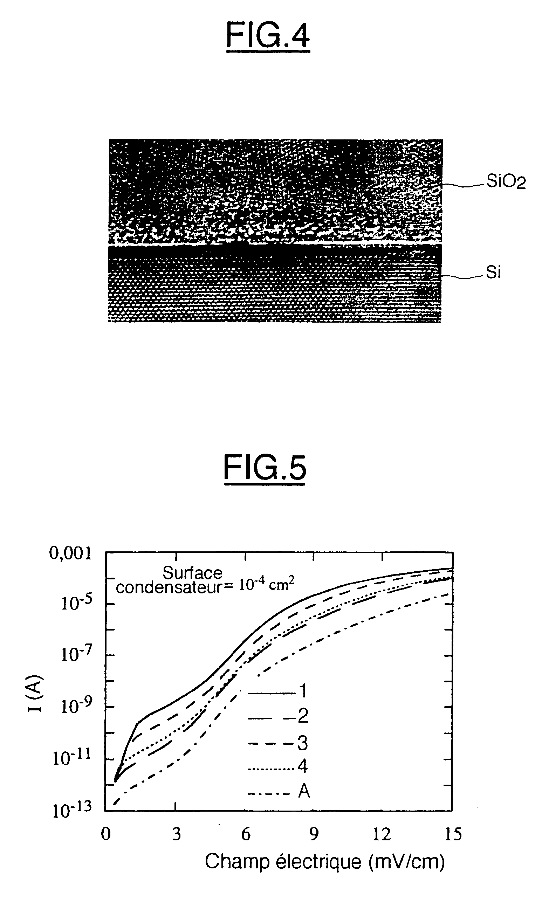

La figure 4 montre que l'interface obtenue entre ce substrat de silicium et la couche d'oxyde de grille SiO₂ est parfaitement plane.

On a réalisé différents dispositifs comportant une couche d'oxyde de grille nitrurée selon l'invention et à titre de comparaison un dispositif comportant une couche d'oxyde de grille non nitrurée :
1 - Dispositif 1 :
   Nitruration : NO gazeux ; 700°C ; 10³ Pa ; 30 secondes.
   Croissance de la couche d'oxyde après nitruration : 02 sec ;
   850°C ; 5 minutes.
   Epaisseur de la couche d'oxyde de grille 2,2 nm.
2 - Dispositif 2 :
   Nitruration : NO gazeux ; 550°C ; 10³ Pa ; 30 secondes.
   Croissance de la couche d'oxyde de grille : O₂ sec (100%) ;
   850°C ; 5 minutes
   Epaisseur de la couche d'oxyde de grille : 2,4nm
3 - Dispositif 3 :
   Nitruration : NO gazeux ; 550°C ; 10³ Pa ; 30 secondes.
   Croissance de la couche d'oxyde de grille : O₂ sec ; 800°C ;
   5 minutes.
   Epaisseur de la couche d'oxyde de grille : 2,2nm
4 - Dispositif 4 :
   Nitruration : NO gazeux ; 550°C ; 10³ Pa ; 5 secondes.
   Croissance de la couche d'oxyde de grille : O₂ sec ; 800°C ;
   5 minutes.
   Epaisseur de la couche d'oxyde de grille : 2,3nm
5 - Dispositif A :
   Croissance de la couche d'oxyde de grille : O₂ sec ; 800°C ;
   5 minutes.
   Epaisseur de la couche d'oxyde de grille : 2,5nm.

## Revendications

1. Procédé de nitruration de la couche d'oxyde de grille d'un dispositif semiconducteur, comprenant les étapes suivantes :
- croissance chimique sur un substrat de silicium (1) d'une couche d'oxyde de silicium natif (2) d'une épaisseur au plus égale à 1nm ;
- traitement du substrat revêtu de la couche d'oxyde de silicium natif avec de l'oxyde nitrique gazeux sous une pression au plus égale à 10⁴ Pa pour obtenir une couche d'oxyde de silicium nitrurée (3), et
- croissance de la couche d'oxyde de grille pour obtenir une couche d'oxyde de grille (4) comportant des atomes d'azote principalement localisés près de l'interface substrat/couche d'oxyde de grille, **caractérisé en ce que** l'étape de traitement avec de l'oxyde nitrique gazeux s'effectue à une température au plus égale à 700°C.

2. Procédé de nitruration selon la revendication 1, **caractérisé en ce que** l'étape de traitement avec de l'oxyde nitrique gazeux s'effectue à une température inférieure à 600°C, et sous une pression inférieure à 10³ Pa.

3. Procédé de nitruration selon la revendication 1 ou 2, **caractérisé en ce que** la croissance chimique de la couche d'oxyde de silicium natif consiste à mettre en contact le substrat de silicium avec une solution aqueuse d'ozone ou de l'ozone gazeux.

4. Procédé selon l'une quelconque des revendications 1 à 3, **caractérisé en ce que** préalablement à l'étape de croissance chimique de la couche d'oxyde de silicium natif, il comprend une étape de nettoyage du substrat avec une solution aqueuse diluée d'acide fluorhydrique.

5. Procédé selon l'une quelconque des revendications précédentes, **caractérisé en ce que** l'étape de croissance de la couche d'oxyde de grille comprend l'oxydation du substrat revêtu de la couche d'oxyde natif nitrurée par une atmosphère d'oxygène sec, pur ou dilué, à une température de 700 à 850°C.

6. Procédé selon l'une quelconque des revendications précédentes, **caractérisé en ce que** le substrat est un substrat de silicium monocristallin ou polycristallin.

7. Procédé selon l'une quelconque des revendications précédentes, **caractérisé en ce que** la couche d'oxyde de grille a une épaisseur égale ou inférieure à 2,5nm.

8. Procédé selon l'une quelconque des revendications précédentes, **caractérisé en ce que** l'étape de traitement avec de l'oxyde nitrique gazeux s'effectue à une température de 550°C et sous une pression de 10³ Pa pendant une durée de 5 à 30 secondes.

## Claims

1. Process for nitriding the gate oxide layer of a semiconductor device, comprising the following steps:
- chemically growing a native silicon oxide layer (2) with a thickness at most equal to 1 nm on a silicon substrate (1),
- treating the substrate coated with the native silicon oxide layer with nitric oxide gas under a pressure at most equal to 10⁴ Pa in order to obtain a nitrided silicon oxide layer (3), and
- growing the gate oxide layer in order to obtain a gate oxide layer (4) including nitrogen atoms principally located close to the substrate/gate oxide layer interface,
**characterized in that** the step of treatment with nitric oxide gas is carried out at a temperature at most equal to 700°C.

2. Nitriding process according to Claim 1,
**characterized in that** the step of treatment with nitric oxide gas is carried out at a temperature below 600°C, and under a pressure of less than 10³ Pa.

3. Nitriding process according to Claim 1 or 2,
**characterized in that** chemical growth of the native silicon oxide layer consists in bringing the silicon substrate into contact with an aqueous ozone solution or ozone gas.

4. Process according to any one of Claims 1 to 3,
**characterized in that**, prior to the step of chemically growing the native silicon oxide layer, it comprises a step of cleaning the substrate with a dilute aqueous hydrofluoric acid solution.

5. Process according to any one of the preceding claims, **characterized in that** the step of growing the gate oxide layer comprises oxidation of the substrate coated with the nitrided native oxide layer with a pure or dilute dry oxygen atmosphere at a temperature of 700 to 850°C.

6. Process according to any one of the preceding claims, **characterized in that** the substrate is a monocrystalline or polycrystalline silicon substrate.

7. Process according to any one of the preceding claims, **characterized in that** the gate oxide layer has a thickness equal to or less than 2.5 nm.

8. Process according to any one of the preceding claims, **characterized in that** the step of treatment with nitric oxide gas is carried out at a temperature of 550°C and under a pressure of 10³ Pa for a time of 5 to 30 seconds.

## Patentansprüche

1. Verfahren zur Nitrierung der Oxidschicht des Gates eines Halbleiterelements, das die folgenden Schritte umfasst:
- chemisches Wachstum auf einem Silizium-Substrat (1) einer Schicht von nativem Siliziumoxid (2) mit einer Dicke von 1 nm oder weniger;
- Behandlung des mit der Schicht von nativem Siliziumoxid überzogenen Substrats mit gasförmigem Stickoxid unter einem Druck von höchstens gleich 10⁴ Pa um eine Schicht nitrierten Siliziumoxids (3) zu erhalten und
- Wachsen der Oxidschicht des Gates, um eine Oxidschicht des Gates (4) zu erhalten, die Stickstoffatome umfasst, die hauptsächlich in der Nähe der Grenzfläche Substrat/Oxidschicht des Gates angeordnet sind, **dadurch gekennzeichnet, dass** der Schritt der Behandlung mit gasförmigem Stickoxid bei einer Temperatur von höchstens 700 °C durchgeführt wird.

2. Nitrierungsverfahren nach Anspruch 1, **dadurch gekennzeichnet, dass** der Schritt der Behandlung mit Stickoxid bei einer Temperatur unter 600 °C und unter einem Druck unter 10³ Pa durchgeführt wird.

3. Nitrierungsverfahren nach Anspruch 1 oder 2, **dadurch gekennzeichnet, dass** das chemische Wachstum der nativen Siliziumoxidschicht darin besteht, das Siliziumsubstrat mit einer wässrigen Ozonlösung oder gasförmigem Ozon in Kontakt zu bringen.

4. Verfahren nach einem der Ansprüche 1 bis 3, **dadurch gekennzeichnet, dass** es vor dem Schritt des chemischen Wachstums der nativen Siliziumoxidschicht einen Reinigungsschritt des Substrats mit einer wässrigen verdünnten Flußsäurelösung umfasst.

5. Verfahren nach einem der vorhergehenden Ansprüche, **dadurch gekennzeichnet, dass** der Schritt des Wachstums der Oxidschicht des Gates die Oxidierung des mit der nitrierten nativen Oxidschicht überzogenen Substrats durch eine Atmosphäre von trockenem, reinem oder verdünntem Sauerstoff bei einer Temperatur von 700 bis 850 °C umfasst.

6. Verfahren nach einem der vorhergehenden Ansprüche, **dadurch gekennzeichnet, dass** das Substrat ein monokristallines oder polykristallines Siliziumsubstrat ist.

7. Verfahren nach einem der vorhergehenden Ansprüche, **dadurch gekennzeichnet, dass** die Oxidschicht des Gates eine Dicke von 2,5 nm oder weniger aufweist.

8. Verfahren nach einem der vorhergehenden Ansprüche, **dadurch gekennzeichnet, dass** der Schritt der Behandlung mit gasförmigem Stickoxid bei einer Temperatur von 550°C unter einem Druck von 10³ Pa während einer Dauer von 5 bis 30 Sekunden durchgeführt wird.
